# EUROPÄISCHE PATENTSCHRIFT

(11) **EP 0 605 679 B1**
(45) Veröffentlichungstag und Bekanntmachung des Hinweises auf die Patenterteilung: **04.03.1998**
(21) Anmeldenummer: 93912950.8
(22) Anmeldetag: 11.06.1993
(51) Int. Cl.: H01L 21/68, B65G 49/07

(54) **VERFAHREN UND VORRICHTUNG ZUM STAPELN VON SUBSTRATEN, DIE DURCH BONDEN MITEINANDER ZU VERBINDEN SIND**
METHOD AND DEVICE FOR STACKING SUBSTRATES WHICH ARE TO BE JOINED BY BONDING
PROCEDE ET DISPOSITIF POUR L'EMPILAGE DE SUBSTRATS DEVANT ETRE LIES PAR BONDING

(30) Priorität: 17.06.1992 DE 4219774
(43) Veröffentlichungstag der Anmeldung: 13.07.1994
(73) Patentinhaber: Mannesmann VDO AG, 60326 Frankfurt (DE)
(72) Erfinder: PLANKENHORN, Horst, D-7730 Villingen-Schwenningen (DE); LINDNER, Thomas, D-7744 Königsfeld 3 (DE)
(86) Internationale Anmeldenummer: EP9301480
(87) Internationale Veröffentlichungsnummer: WO9326040

(56) Entgegenhaltungen:
- EP-A- 0 269 076
- US-A- 4 257 274
- US-A- 4 322 980
- US-A- 4 490 111
- US-A- 4 899 921
- US-A- 4 938 654

## Beschreibung

Die vorliegende Erfindung betrifft ein Verfahren und eine Vorrichtung gemäß dem Oberbegriff des Anspruches 1.

Der Gegenstand der Erfindung findet insbesondere bei der Herstellung von in Schichtbauweise gefertigten Sensoren Anwendung. So können beispielsweise Druck- oder Beschleunigungssensoren besonders vorteilhaft mittels aufeinandergeschichteter Substrate hergestellt werden, wobei die Substrate zuvor in geeigneter Weise behandelt, d. h. insbesondere mit bestimmten feinen Strukturen versehen worden sind.

Um nun die Substrate miteinander zu verbinden, sind bereits verschiedene Techniken entwickelt worden. An dieser Stelle sollen nur folgende, in der Fachwelt bekannte Verfahren ohne nähere Erläuterung erwähnt werden:
* anodisches Bonden
* silicon fusion bonding
* eutectic bonding
* low temperature glass bonding

Allen diesen Bondverfahren ist gemeinsam, daß die Oberfläche der Substrate poliert und gründlich gereinigt sein muß, daß die zu verbondenden Substrate deshalb in einer weitestgehend partikelfreien Umgebung gehandhabt werden müssen, daß sehr hohe Anforderungen an die Ebenheit der Auflageflächen von den einzelnen Substraten zu stellen sind und daß das Miteinanderverbinden der Substrate frei von mechanischen Spannungen erfolgen muß, um lückenhafte Freiräume zwischen den Substraten zu vermeiden. Die Nichtbeachtung dieser Grundanforderungen mindert die Qualität der miteinander zu verbindenden Flächen erheblich. Sie kann die beabsichtigte Funktion des herzustellenden Produkts sogar in Frage stellen.

Die vorliegende Erfindung soll im folgenden zur besseren Verständlichkeit exemplarisch am Verfahren des anodischen Bondens geschildert werden, gleichwohl sie sich natürlich nicht nur auf dieses spezielle Verfahren beschränkt, sondern auch bei den anderen Bondverfahren anwendbar ist.

Anodisches Bonden dient zur Herstellung einer hermetischen und mechanisch festen Verbindung zwischen Glas- und Metallsubstraten oder der Verbindung zwischen Glas- und Halbleitersubstraten. Dazu müssen die aufeinander gelegten Substrate auf eine Temperatur von einigen hundert °C erwärmt und mit einer Gleichspannung von rund 1000 Volt beaufschlagt werden. Elektrostatische Kräfte und die Wanderung von Ionen führen schließlich zu einer irreversiblen chemischen Verbindung an der Grenzschicht zwischen den einzelnen Substraten.

Dieses Fertigungsverfahren findet beispielsweise bei der Herstellung von Beschleunigungssensoren Anwendung. Durch anisotropes Ätzen können in einem Halbleitersubstrat Strukturen im Mikrometerbereich eingebracht werden. Dabei werden in vielen Anwendungsfällen die Substrate nicht durchgeätzt, so daß das Substrat "undurchsichtig" bleibt. Ein derart strukturiertes Halbleitersubstrat wird zur Herstellung eines funktionsfähigen Sensors beidseitig mit Glassubstraten abgedeckt, wobei die Glassubstrate zumeist auf der dem Halbleitersubstrat zugewandten Seite ebenfalls feine Strukturen aufweisen, beispielsweise durch Metallisierung oder in eingeätzten Kanälen ausgebildete Leiterbahnen und Kontaktierungen für den Sensor, die ihrerseits zu den aktiven, d. h. an der Wandlung der Meßgröße beteiligten Strukturen des Halbleitersubstrates auszurichten sind, siehe z.B. US-A-4 257 274.

Bei der Herstellung derartiger Mehrschichtsubstratpakete tritt ein Problem auf, wenn eines oder mehrere der hochgenau zueinander auszurichtenden Substrate nicht durchsichtig ist bzw. sind.

Es sind Verfahren und Vorrichtungen bekannt, die den Aufbau des aus mehreren Substraten bestehenden Substratpaketes schichtweise vornehmen, indem sie zuerst eine Glasschicht zu dem Halbleitersubstrat ausrichten und mit diesem durch Bonden verbinden und danach das so gebildete Zweischichtpaket wenden, um anschließend die zweite Glasschicht auf der anderen Oberfläche des Halbleitersubstrates aufzubringen.

Dieses Verfahren hat aber mehrere Nachteile. Zum einen besitzen Glas und Halbleiterwerkstoffe unterschiedliche Wärmeausdehnungskoeffizienten, so daß sicht, beim ersten Bonden des Zweischichtpaketes dieses nach dem Bimetallprinzip verbiegt. Die durch die Wölbung bedingte Unebenheit muß bei der Ausrichtung des zweiten Glassubstrates durch Druckkraft kompensiert werden. Bei diesem Verfahren ist es unvermeidbar, daß das so hergestellte Mehrschichtpaket unsymmetrisch verspannt.

Vorrichtungen zur Durchführung des beschriebenen Verfahrens verfügen oftmals über eine Heizvorrichtung, die so ausgebildet ist, daß das zu bondende Substratpaket nur einseitig erwärmt werden kann. Beim ersten Bondvorgang wird zum Beispiel das Halbleitersubstrat auf eine Heizplatte gelegt, beim zweiten Bondvorgang kommt dann das Glassubstrat auf der Heizplatte zu liegen. Das Glassubstrat besitzt jedoch eine wesentlich schlechtere Wärmeleitfähigkeit als das Halbleitersubstrat. Damit ist die Temperatur der zu bondenden Grenzflächen in beiden Fällen unterschiedlich. Eine Temperaturregelung an der Bondfläche bringt keine Verbesserung, da die verschieden hohen Temperaturen der Heizvorrichtung wiederum in nachteiliger Weise einen Verzug des Substratpaketes bewirken.

Ein weiterer Nachteil bei der bekannten, beschriebenen Vorrichtung zur Durchführung des Herstellungsverfahrens besteht darin, daß beim zweiten Bondvorgang das erste Substratpaket elektrisch umgepolt wird, da die Heizplatte zumeist durch den Aufbau bedingt fest mit dem Kathodenpotential verbunden ist. Die Anoden-Kontaktierung sollte jedoch stets am Halbleitersubstrat angelegt werden. Eine Beeinträchtigung der mechanischen Eigenschaften der ersten Bondverbindung ist durch den chemischen Prozeß an der Grenzfläche, der durch das Umpolen ausgelöst wird, nicht völlig auszuschließen.

US-A-4 938 654 offenbart ein automatisches Wafer Inspektionssystem, bei dem Wafer unter einem Mikroskop auf einem Koordinatentisch positioniert werden können.

Der vorliegenden Erfindung liegt nun die Aufgabe zugrunde, ein Verfahren und eine entsprechende Vorrichtung zu schaffen, um unter Einhaltung einer sehr hohen Justiergenauigkeit zueinander gemäß ihrer Struktur auszurichtende Substrate, von denen wenigstens eins nicht transparent ist, miteinander zu verbonden, wobei Taktzeiten zu realisieren sind, die eine Serienfertigung der zu bondenden Substratpakete gestatten.

Als Randbedingung muß die Lösung berücksichtigen, daß die Vorrichtung den besonderen Anforderungen gerecht werden muß, die an Vorrichtungen zu stellen sind, die in einem Reinraum eingesetzt werden. Dazu zählt insbesondere die Partikelfreiheit, d. h. es ist sicherzustellen, daß keine Komponente der Vorrichtung Partikel erzeugt. So dürfen z. B. für Transportmittel keine Abrieb verursachenden Führungen eingesetzt werden und bei Verwendung von pneumatischen Antrieben ist die Abluft unterhalb der Arbeitsfläche abzuleiten.

Die Aufgabe wird gemäß den kennzeichnenden Merkmalen der Ansprüche 1 und 2 gelöst. Die weiteren Ansprüche beziehen sich auf vorteilhafte Weiterbildungen der erfindungsgemäßen Lösung.

Die gefundene Lösung löst auf vorteilhafte Weise das gestellte Problem und vermeidet vollständig die Nachteile bekannter Verfahren und Vorrichtungen. Besonders vorteilhaft ist die räumliche Trennung von Justier- und Heizeinheit. Die Justiereinheit, die die Lage der Substrate auf wenige Mikrometer genau ausrichtet, wird so nicht mit den hohen Temperaturen belastet, die zum Bonden erforderlich sind. Die Längen- und Volumenausdehnung der Mittel zur Aufnahme und Halterung der Substrate sowie die der Substrate selbst läge bei den erforderlichen Temperaturen in der gleichen Größenordnung wie die aufgrund der Strukturbreiten benötigte Justiergenauigkeit oder würde diese sogar übersteigen. Daher erfolgt erfindungsgemäß in einem ersten Arbeitsbereich einer Handhabungsvorrichtung die hochgenaue Ausrichtung der Substrate zueinander entsprechend ihrer Struktur. Mittels einer Transporteinrichtung werden die Substrate dann zu einem zweiten Arbeitsbereich der Handhabungsvorrichtung befördert und dort in definierter Weise aufeinander abgelegt, bevor alle Substrate zusammen als zueinander ausgerichtetes Substratpaket der Heizvorrichtung zugeführt werden.

Alle aufeinanderliegenden Substrate werden gleichzeitig in nur einem Arbeitsgang gebondet, wodurch die Nachteile des thermischen Verzugs durch schrittweises Bonden vollständig vermieden und die Fertigungsdauer deutlich verkürzt werden. Das Bonden ist im gesamten Herstellungsprozeß einer der zeitintensivster Fertigungsschritte. Im Hinblick auf eine Serienfertigung von Sensoren wird durch diese Maßnahme die Taktzeit entscheidend verkürzt, insbesondere wenn die Heizvorrichtung so ausgelegt ist, daß sie mehrere Substratpakete gleichzeitig aufnehmen kann. Durch das gleichzeitige Bonden aller Grenzschichten des Substratpaketes werden auch die Folgen vermieden, die durch das Umpolen zuvor gebondeter Schichten entstehen.

Im folgenden soll die Erfindung an einem Ausführungsbeispiel und anhand von 3 Figuren näher erläutert werden.

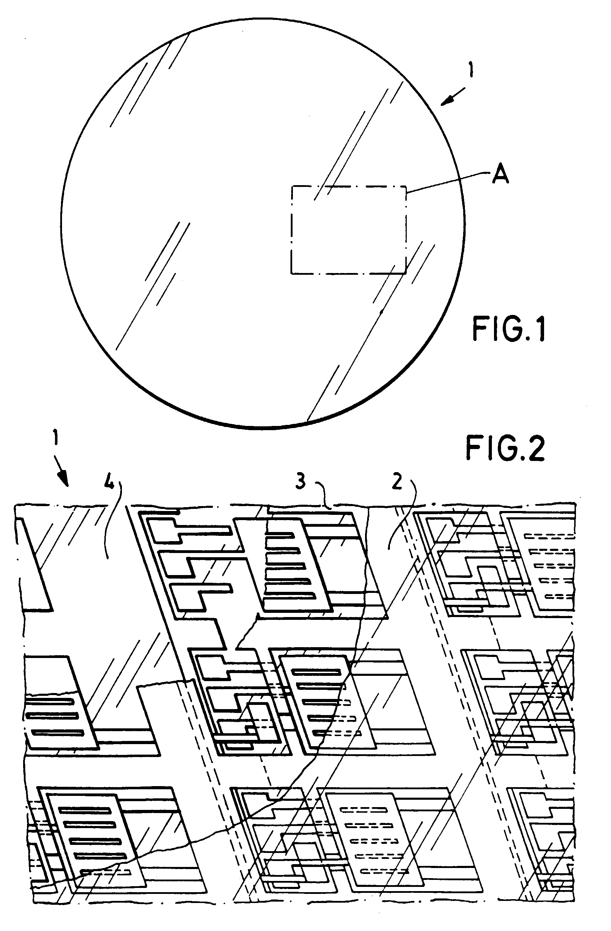

Figur 1 zeigt ein Substratpaket 1 in der Draufsicht. In Figur 2 ist ein Ausschnitt A aus dem Substratpaket der Figur 1 vergrößert dargestellt, wobei zusätzlich durch einen Aufschnitt der Schichtaufbau von drei Substraten 2, 3 und 4 mit den feinen und komplexen Strukturen erkennbar wird, die in diese Substrate ein- bzw. auf diesen aufgebracht sind. Diese beiden Figuren verdeutlichen das Problem, das entsteht, wenn diese Substrate in definierter Weise aufeinanderzulegen sind und mindestens eines der Substrate nicht transparent ist, wie hier z. B. das Substrat 3.

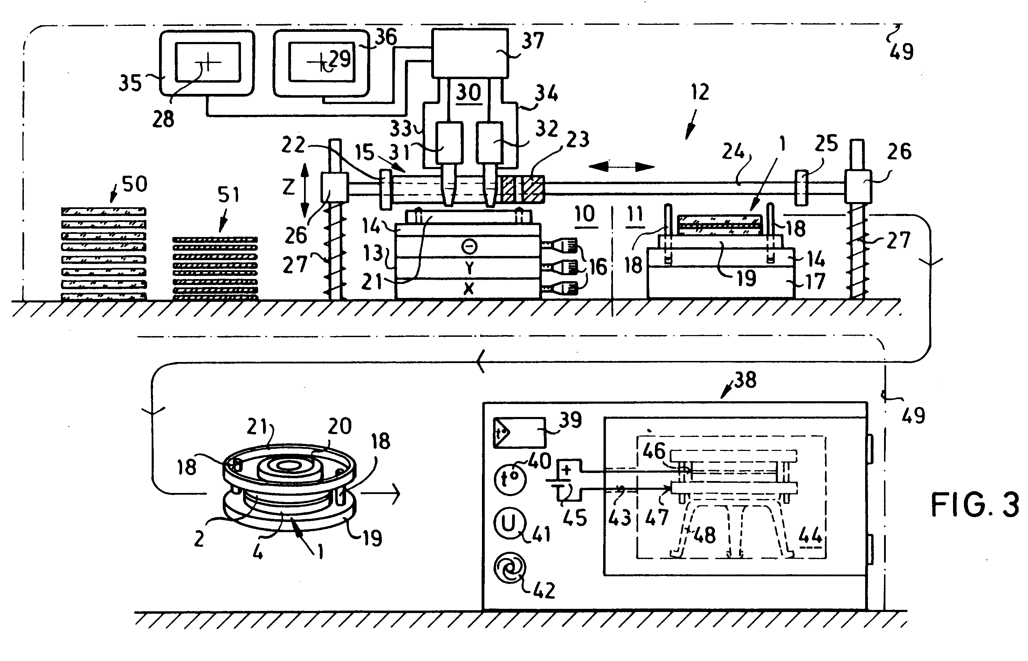

Figur 3 zeigt in schematischer Darstellung die erfindungsgemäße Vorrichtung zur Durchführung des Verfahrens.

Das Verfahren gliedert sich in folgende wesentliche Arbeitschritte:
- Justieren
- Transportieren
- Stapeln
- Bonden

Das Justieren bzw. Ausrichten eines Substrates erfolgt in einem ersten Arbeitsbereich 10 einer Handhabungsvorrichtung 12, um die mechanischen Komponenten der Justiereinheit keiner hohen thermischen Belastung auszusetzen. Abgesehen von einem erhöhten Verschleiß und einer bedeutend aufwendigeren Konstruktion der gesamten Handhabungsvorrichtung 12 und insbesondere der Justiereinheit 13, wäre es bei Temperaturen von 300 °C und mehr andernfalls sehr schwierig, die erforderliche Justiergenauigkeit von weniger als 10 Mikrometer reproduzierbar einzuhalten.

Die Handhabungsvorrichtung 12 verfügt über zwei Arbeitsbereiche 10 und 11, in denen jeweils Mittel 14 zur Aufnahme und Halterung von Substraten vorgesehen sind, sowie über Transportmittel 15, die beide Arbeitsbereiche 10 und 11 miteinander verbinden und es ermöglichen, daß ein Substrat vom ersten zum zweiten Arbeitsbereich befördert und dort in definierter Weise abgelegt wird.

Die Aufnahmemittel 14 im ersten Arbeitsbereich 10 bestehen zum Beispiel aus einem tellerförmigen Chuck, auf den manuell oder automatisch ein Substrat gelegt und mittels Unterdruck festgehalten wird, sobald die Vakuumansaugung aktiviert wird. Die Mittel zur Vakuumansaugung sind in der Figur 3 nicht dargestellt.

Der Vakuumchuck zur Substrataufnahme im ersten Arbeitsbereich 10 ist auf einem um 360° drehbaren xy-Koordinatentisch 13 gelagert. Die Positionierungen erfolgen mittels Präzisionantriebe 16. So beträgt die Verschiebungsgenauigkeit für beide Achsen 1 Mikrometer. Rotatorisch wird eine Einstellgenauigkeit von 0,1° erreicht.

Im zweiten Arbeitsbereich 11 ist ein Ablagetisch 17 vorgesehen, auf dem der untere Teil der Substrataufnahme durch zwei Paßstifte 18 arretiert aufliegt. Die Substrataufnahme 19 besteht aus einer Platte, die aus einem elektrisch leitenden Werkstoff besteht und substratseitig mit Kanälen für eine Ansaugung durch Unterdruck und rückseitig mit einem fest angebrachten Magneten 20 versehen ist. Ein symmetrisches Gegenstück 21 wird ebenfalls über die Paßstifte 18 auf die Substrataufnahme 19 abgelegt und hält das dazwischenliegende Substratpaket 1 durch magnetische Anziehung zusammen. Über die beiden Paßstifte 18 sind die beiden Halteplatten 19 und 21 leitend miteinander verbunden. Die beiden an den Halteplatten 19 und 21 anliegenden Glassubstrate 2 und 4 sind damit für das anschließende Bonden großflächig kontaktiert.

Um thermische Verspannungen in dem zu bondenden Substratpaket 1 zu vermeiden, ist es empfehlenswert, die Mittel 19 und 21 zur Aufnahme und Halterung der Substrate aus einem Werkstoff auszubilden, dessen thermischer Ausdehnungskoeffizient dem der Substrate möglichst gut entspricht. Die Temperaturkoeffizienten der miteinander zu verbondenen Substrate ist zwar in aller Regel unterschiedlich, jedoch liegen sie zumeist in der gleichen Größenordnung. Es trägt erheblich zur Qualität der Bondverbindung bei, wenn für die Substrataufnahmen ein Werkstoff ausgewählt wird, dessen thermischer Ausdehnungskoeffizient sich möglichst gut dieser Größenordnung nähert, um durch die Erwärmung des Gesamtpaketes thermische Verspannungen zu vermeiden.

Die Transportmittel 15 zum Befördern der Substrate vom ersten zum zweiten Arbeitsbereich bestehen beispielsweise aus einem gabelförmigen Transportschlitten 23, dessen Gabel gemäß der Schnittdarstellung in der Figur 3 nach links geöffnet ist, um mit dem Mikroskopsystem 31, 32 nicht zu kollidieren. Der Schlitten ist ebenfalls mit Mitteln zur Substrataufnahme durch Vakuumansaugung ausgestattet, die jedoch in der Figur 3 nicht dargestellt sind. Der Transportschlitten 23 ist auf Längsführungen 24 reibungsarm gelagert und zwischen Festanschlägen 22 und 25 verfahrbar. Außerdem ist eine Hubeinrichtung 26 vorgesehen, um den Transportschlitten 23 gegen den Justiertisch 13 im ersten Arbeitsbereich 10 bzw. gegen den Ablagetisch 17 im zweiten Arbeitsbereich 11 abzusenken. Zur Minderung und Begrenzung der Auflagekraft des Schlittens 23 auf den Tischen wirkt der Hub Z gegen eine Feder 27.

Die Problematik des Ausrichtens der Substrate ergibt sich aus der Tatsache, daß zumindest das Halbleitersubstrat nicht durchsichtig ist. Deshalb schlägt die erfindungsgemäße Lösung vor, jedes Substrat relativ zu Sollpositionen auszurichten. Vorzugsweise werden dazu Fadenkreuze 28, 29 in einem ortsfesten Mikroskopsystem 30 verwendet.

In der bevorzugten Ausführung werden zwei Justiermarken des Substrates mit Hilfe eines Splitfield-Mikroskops abgebildet. Ein Splitfield-Mikroskop hat die Eigenschaft, daß es räumlich getrennte Justiermarken simultan abzubilden vermag. Hier besteht es aus zwei Auflichtmikroskope 31 und 32 mit koaxialer Polarisationslichtführung, die durch Lichtleiter 33, 34 von einer Kaltlichtquelle beleuchtet werden. Die beiden Auflichtmikroskope 31 und 32 sind z. B. mit 10-fach vergrößernden Objektiven auf einer Traverse montiert und in ihren optischen Parametern verstellbar. Die eigentliche Abbildung erfolgt jeweils durch eine Halbleiterkamera auf je einem Monitor 35, 36 als Abbildungsträger. In das Abbild des Substrates werden durch zwei Fadenkreuzgeber verstellbare vertikale und horizontale Meßlinien eingeblendet. Diese bilden die ortsfesten Sollpositionen, nach denen das Substrat im ersten Arbeitsbereich 10 ausgerichtet wird. In der Figur 3 sind die Einzelkomponenten Kaltlichtquelle, Halbleiterkamera und die für den Betrieb dieser Einrichtungen benötigte Steuereinheit in dem Feld 37 zusammengefaßt.

Die Justiermarken des Substrates werden entweder durch die aktiven Strukturen des Substrates selbst gebildet oder es werden eigens für die Justierung ein- oder aufgebrachte Strukturen benutzt. Die auf den Monitoren 35 und 36 zu beobachtenden Istpositionen werden mittels der Präzisionsantriebe 16 des Koordinatentisches 13 auf die durch die Fadenkreuze 28 und 29 vorgegebene Sollpositionen abgeglichen.

Um die benötigte Justiergenauigkeit einhalten zu können, ist eine hohe mechanische Stabilität der Handhabungsvorrichtung 12 erforderlich. Hier sind insbesondere der Abstand zwischen Mikroskop und der Substrataufnahme zu erwähnen wie auch die Reproduzierbarkeit der Positionierung des Transportschlittens 23 an den Festanschlägen 22 und 25.

Ebenso muß auch das Aufnehmen und Ablegen der Substrate in exakt definierter Weise , d. h. äußerst positionsgenau erfolgen. Dazu fährt der Transportschlitten 23 aus seiner Ruheposition über dem Ablagetisch 17 im zweiten Arbeitsbereich 11 der Handhabungsvorrichtung 12 an den linken Festanschlag 22 über dem Justiertisch 13 im ersten Arbeitsbereich 10. Dort wird er abgesenkt, bis seine Mittel zur Substrataufnahme auf dem zu transportierenden, justierten Substrat aufliegen. Eine Steuerschaltung, die in der Figur 3 nicht dargestellt ist, überwacht das Aufnehmen des Substrates mittels Vakuumansaugung durch die Substrataufnahmemittel des Transportschlittens 23, da gleichzeitig die Halterung des Substrates in der Justiereinheit gelöst werden muß. Der Schaltpunkt, wann ein Substrat entweder vom Transportschlitten 23 oder von der Justiereinheit gehalten wird, ist variabel einstellbar.

Nachdem ein Substrat vom Transportschlitten 23 aufgenommen worden ist, hebt sich der Schlitten 23 an und fährt gegen den rechten Festanschlag 25 im zweiten Arbeitsbereich 11 der Handhabungsvorrichtung 12, wo der Schlitten auf den Ablagetisch 17 hin abgesenkt wird. Nur das erste im zweiten Arbeitsbereich abzulegende Substrat wird in der dort vorhandenen Aufnahme mit Vakuum angesaugt, wobei der Übergang vom Lösen in den Haltemitteln des Transportschlittens 23 zum Halten des Substrats auf dem Ablagetisch 17 ähnlich wie im ersten Arbeitsbereich 10 in kontrollierter Weise verläuft. Alle weiteren Substrate werden auf dem vorangegangen Substrat nur aufgelegt, wobei vor dem Hochfahren des Transportschlittens 23 in seine Ruheposition eine einstellbare Zeitverzögerung zwischen dem Absenken und Abschalten des Vakuums vorgesehen ist, um das Luftpolster zwischen den Substraten zu verdrängen.

Sind alle gewünschten Substrate in der beschriebenen Weise auf dem Ablagetisch 17 übereinander gestapelt worden, so wie es in der Figur 3 gezeigt ist, wird die obere Halteplatte 21 durch die Paßstifte 18 geführt auf das Substratpaket 1 aufgelegt. Diese obere Halteplatte 21 benötigt daher keine Justiermarken. Sie wird durch magnetische Anziehung gehalten.

Das gesamte Paket, bestehend aus den gestapelten Substraten und die den Stapel einfassenden Halteplatten 19 und 21, wird nun einer Heizvorrichtung 38 zugeführt. Eine Temperaturregelschaltung 39 hält die eingestellte Temperatur auf mindestens 1°C genau. Es ist zweckmäßig, wenn die Heizvorrichtung 38 über eine Temperaturanzeige 40, ein Anzeigeinstrument 41 für die von der Hochspannungsquelle 45 abgegebene Bondspannung und Mittel 42 zur allseitig und gleichmäßigen Erwärmung des Substratpaketes verfügt. Das erfindungsgemäße Verfahren ist jedoch davon unabhängig, ob diese Komponenten in der Heizvorrichtung 38 integriert sind oder nicht.

Die Heizvorrichtung 38 verfügt auch über eine Hochspannungsdurchführung 43 in den eigentlichen Heizraum 44 der Heizvorrichtung 38, um dem im Heizraum 44 befindlichen Substratpaket 1 die zum Bonden benötigte elektrische Energie von einer Hochspannungsquelle 45 zuzuführen. Zur elektrischen Kontaktierung des Substratpaketes sind in der Heizvorrichtung Mittel 46, 47 vorgesehen, die die Anode der Gleichspannungsquelle 45 über einen Kontakt an das Halbleitersubstrat 3 legen und die Glassubstrate 2, 4 großflächig mit der Kathode verbinden. Mehrschichtige Substratpakete können auf diese Weise in nur einem Arbeitsgang vorteilhaft gleichzeitig gebondet werden. Es mag vorteilhaft sein, das Substratpaket im Heizraum 44 auf einem Hilfsgestell 48 zu lagern.

Durch die strichpunktierte Umrandung 49 aller Vorrichtungseinheiten zur Durchführung des erfindungsgemäßen Verfahrens soll angedeutet sein, daß diese Vorrichtungeinheiten in einer Reinraumumgebung betrieben werden. Das trifft insbesondere auf die Handhabungsvorrichtung 12 und die dieser zuzuführenden Substrate zu. In der Figur 3 sind andeutungsweise zwei Stapel 50 und 51 verschiedener Substratsorten dargestellt, z. B. Glassubstrate 2,4 und Halbleitersubstrate 3, die in einem Magazin oder einem anderen geeigneten Behältnis, das nicht dargestellt ist, zur weiteren Bearbeitung an der Handhabungsvorrichtung 12 bereitgestellt werden. Nachdem die Substrate aufeinandergestapelt und durch die beiden Substrataufnahmen 19 und 21 staubdicht eingefaßt sind, kann nach rein praktischen Gesichtspunkten die Heizvorrichtung 38 räumlich nahe an der Handhabungsvorrichtung 12 ebenfalls innerhalb des Reinraumes aufgestellt sein, um eventuell eine Beschickung des Heizraumes 44 durch eine Erweiterung der Handhabungsvorrichtung 12 zu ermöglichen. Diese Ausführung bezüglich der Anordnung der Heizvorrichtung 38 ist zweckmäßig, aber im Gegensatz zur Anordnung der Handhabungsvorrichtung 12 für die Durchführung des erfindungsgemäßen Verfahrens nicht zwingend erforderlich.

Die so geschaffene Vorrichtung wird vollständig den Anforderungen gerecht, mehrschichtige Substratpakete bei geringen Taktzeiten in einer für die Serienfertigung von Sensoren geeigneten Weise ganzflächig bei gleichmäßiger Erwärmung zu verbonden, wobei die strukturierten Substrate zuvor hochgenau entsprechend ihrer Struktur in einem von der Heizvorrichtung getrennten Arbeitsbereich zueinander ausgerichtet werden. Alle beschriebenen Maßnahmen der erfindungsgemäßen Lösung tragen dazu bei, daß bezüglich des zu verbondenden Substratpaketes nach Abschluß aller Verfahrensschritte insgesamt eine Justiergenauigkeit von 10 Mikrometer oder besser reproduzierbar erreicht wird.

Die vorgeschlagene Lösung eignet sich für eine automatische Fertigung, da ohne weiteres für den mechanischen Bewegungsablauf pneumatische oder elektrische Antriebe eingesetzt werden können und selbst die Justierung durch elektronische Bildauswertung mit anschließender Lageregelung der Substrataufnahme in der Justiereinheit bedarfsweise vollautomatisch ablaufen kann. Ebenso kann die Vorrichtung in reinraumtauglicher Weise aufgebaut werden, womit allen Aspekten der Aufgabenstellung Rechnung getragen wird.

## Patentansprüche

1. Verfahren zum Herstellen eines Beschleunigungssensors,
a) wobei der Beschleunigungssensor aus geschichteten Substraten (2, 3, 4) mit planparallelen ebenen Flächen besteht, die durch Bonden unlösbar vollflächig miteinander zu verbinden sind,
b) wobei mindestens ein erstes Substrat (3) auf seiner Oberfläche durch Ätzen gefertigte Strukturen aufweist und mindestens ein weiteres Substrat auf seiner Oberfläche ebenfalls feine, für die Funktion des Beschleunigungssensors relevante Strukturen aufweist,
c) wobei zumindest das erste Substrat (3) mit den durch Ätzen gefertigten Strukturen aus einem nicht transparenten Werkstoff besteht,
d) wobei das erste mit mindestens je eines der weiteren Substrate (2, 4) in Vorbereitung auf ihr Zusammenfügen durch Bonden derart mit einer im Mikrometerbereich liegenden Genauigkeit zueinander auszurichten sind, daß sich einander zugewandte Gestaltungsmerkmale ihrer Strukturen zu einem funktionsfähigen Beschleunigungssensor ergänzen,
dadurch gekennzeichnet,
e) daß nacheinander die aufeinander zu stapelnden Substrate (2, 3, 4) zuerst in einem ersten Arbeitsbereich (10) einer Handhabungsvorrichtung (12) ausgerichtet, danach zu einem zweiten Arbeitsbereich (11) der Handhabungsvorrichtung (12) transportiert und dort entsprechend der getroffenen Ausrichtung aufeinander abgelegt werden, wobei
f) auf das im ersten Arbeitsbereich (10) der Handhabungsvorrichtung (12) befindliche Substrat ein Mikroskop (31, 32) gerichtet ist, um zwei räumlich getrennte Justiermarken des Substrates auf einen Abbildungsträger (35, 36) abzubilden, wobei die Justiermarken durch Gestaltungsmerkmale der Strukturen des Substrates selbst oder getrennt von diesen durch eigenständige Markierungen auf der Oberfläche der Substrate gebildet werden und
g) die Istposition des im ersten Arbeitsbereich (10) der Handhabungsvorrichtung (12) befindlichen Substrates durch Drehen und Verschieben beweglich gelagerten Mittel zur Aufnahme und Halterung (14) für das Substrat solange verändert wird, bis die Abbildung der Justiermarken mit einer auf dem Abbildungsträger (35, 36) vorgegebenen Sollposition (28, 29) übereinstimmt,
h) und daß das Substratpaket (1) unter Beibehaltung der zuvor getroffenen Ausrichtung seiner Substrate in seiner Gesamtheit eingespannt zwischen einer das Substratpaket (1) zu beiden Stirnseiten einfassenden Halterung (19, 21) zum gleichzeitigen Bonden aller seiner Substrate (2, 3, 4) in einem einzigen Arbeitsgang einer räumlich von dem dem Ausrichten der Substrate dienenden Handhabungsbereich (10) getrennten Heizvorrichtung (38) zur allseitig gleichmäßigen Erwärmung zugeführt wird.

2. Vorrichtung zur Durchführung des Verfahrens nach Anspruch 1, wonach mehrere strukturierte, entsprechend ihrer Struktur zueinander auszurichtende Substrate (2,3,4) vor ihrem Zusammenfügen durch Bonden zu einem Substratpaket (1) übereinander zu stapeln sind, wobei mindestens ein Substrat (3) nicht transparent ist und eine feine, vielgestaltige, geometrisch unregelmäßige Struktur aufweist, wobei Gestaltungsmerkmale der Struktur dieses Substrats an Gestaltungsmerkmalen von wenigstens einer der übrigen Substrate auszurichten sind,
dadurch gekennzeichnet,
a) daß in einem ersten Arbeitsbereich (10) einer Handhabungsvorrichtung (12) Mittel zur Aufnahme und Halterung (14) eines Substrates (2, 3, 4) vorgesehen sind,
b) daß sich die Mittel zur Aufnahme des Substrats auf einer als Koordinatentisch (13) ausgebildeten Justiereinheit befinden, wobei der Koordinatentisch (13) für alle drei Freiheitsgrade einer Ebene (X, Y, Theta) zur Lageveränderung eines auszurichtenden Substrats über Präzisionsantriebe (16) verfügt,
c) daß in dem ersten Arbeitsbereich (10) der Handhabungsvorrichtung (12) ein Mikroskopsystem (30) vorgesehen ist, welches zwei räumlich getrennte Justiermarken eines in den Aufnahmemitteln befindlichen Substrates abbildet,
d) daß in einem zweiten Arbeitsbereich (11) der Handhabungsvorrichtung (12) Mittel zur Aufnahme und Halterung (14) der ausgerichteten, nacheinander und aufeinander abzulegenden Substrate vorgesehen sind, daß eine Halterung (19,21), die das Substratpaket (1) zu beiden Stirnseiten einspannt, vorgesehen ist,
e) daß Transportmittel (15) vorgesehen sind, die ein im ersten Arbeitsbereich (10) ausgerichtetes Substrat zu dem zweiten Arbeitsbereich (11) der Handhabungsvorrichtung (12) transportieren und dort entsprechend der im ersten Arbeitsbereich (10) getroffenen Ausrichtung ablegen und
f) daß räumlich getrennt von dem ersten Arbeitsbereich (10) eine Heizvorrichtung (38) vorgesehen ist, dem das gesamte Substratpaket (1) zugeführt wird, um es allseitig gleichmäßig für den Prozeß des Bondens zu erwärmen.

3. Vorrichtung nach Anspruch 2,
dadurch gekennzeichnet,
daß das in dem ersten Arbeitsbereich (10) der Handhabungsvorrichtung (12) vorgesehene Mikroskopsystem (30) ein Splitfield-Mikroskop ist, welches die räumlich getrennten Justiermarken simultan abbildet.

4. Vorrichtung nach Anspruch 2 oder 3, dadurch gekennzeichnet, daß die Halterung (19, 21) des Substratpaketes (1) aus einem Werkstoff gebildet sind, dessen thermischer Ausdehnungskoeffizient dem der Substrate (2, 3, 4) entspricht, und daß diese Halterung während des Bondens die anliegenden Substrate (2, 4) großflächig Kontaktiert.

5. Vorrichtung nach einem der Ansprüche 2 bis 4,
dadurch gekennzeichnet,
daß die Transportmittel aus einem Transportschlitten (23), der zwischen Festanschlägen (22,25) verfahrbar ist, und einer Hubeinrichtung (26) bestehen, daß die Mittel (14) zur Aufnahme und Halterung Mittel zur Vakuumansaugung enthalten, daß
die Handhabungsvorrichtung (12) zur Wahrung des Abstandes zwischen dem Mikroskopsystem (30) und der Mittel zur Aufnahme und Halterung (14) sowie zur Wahrung der Reproduzierbarkeit der Positionierung des Transportschlittens (23) an den Festanschlägen (22, 25) und in der Hubbewegung (Z) eine hohe mechanische Stabilität aufweist, daß
eine einstellbare Zeitverzögerung zwischen dem Absenken des Transportschlittens (23) und dem Abschalten der Vakuumansaugung in der Substrataufnahme (14) zur Verdrängung des Luftpolsters zwischen den zu stapelnden Substraten (2, 3, 4) vorgesehen ist, und daß
das Zusammenhalten des Substratpaketes (1) mittels der den Substratstapel einfassenden, sich durch magnetische Anziehung gegenseitig haltenden und der durch Paßstifte (18) zueinander geführten Halteplatten (19, 21) erfolgt.

6. Vorrichtung nach Anspruch 2,
dadurch gekennzeichnet,
daß die Heizvorrichtung (38) so dimensioniert ist, daß sie für den Bondvorgang auch mehrere Substratpakete (1) gleichzeitig aufnehmen kann.

7. Vorrichtung nach Anspruch 2,
dadurch gekennzeichnet,
daß im Heizraum (44) der Heizvorrichtung (38) Mittel vorgesehen sind, die beim Einlegen eines oder mehrerer mehrschichtiger Glas-Halbleiter-Glas-Substratpakete (1) die Anode einer Hochspannungsquelle (45) an das oder die Halbleitersubstrat(e) (3) legen und die Glassubstrate (2, 4) mit dem Kathodenpotential verbinden.

## Claims

1. Process for manufacturing an acceleration sensor,
a) the acceleration sensor comprising layered substrates (2, 3, 4) having plane-parallel even surfaces which are to be joined to one another over the full area in a non-detachable manner by bonding,
b) at least one first substrate (3) having structures on its surface which are produced by etching, and at least one further substrate likewise having fine structures on its surface which are relevant for the functioning of the acceleration sensor,
c) at least the first substrate (3) with the structures produced by etching consisting of a non-transparent material,
d) the first substrate, together with in each case at least one of the further substrates (2, 4), having to be aligned with one another, in preparation for joining them together by bonding, with an accuracy in the micrometre range such that mutually facing design features of their structures complement one another to form a functional acceleration sensor,
characterised
e) in that the substrates (2, 3, 4) to be stacked one on top of the other are first of all successively aligned in a first working region (10) of a handling apparatus (12), then transported to a second working region (11) of the handling apparatus (12) and deposited there one on top of the other in accordance with the effected alignment,
f) a microscope (31, 32) being directed at the substrate situated in the first working region (10) of the handling apparatus (12) in order to image two spatially separated adjusting marks of the substrate on an imaging medium (35, 36), the adjusting marks being formed by design features of the structures of the substrate itself or, separate from these, by independent markings on the surface of the substrates and
g) the actual position of the substrate situated in the first working region (10) of the handling apparatus (12) being changed by rotating and displacing movably mounted receiving and holding means (14) for the substrate until the image of the adjusting marks coincides with a desired position (28, 29) preset on the imaging medium (35, 36),
h) and in that the substrate package (1) is fed, while retaining the previously effected alignment of its substrates, in its entirety, clamped between a holder (19, 21) enclosing the substrate package (1) at both end faces for the simultaneous bonding of all of its substrates (2, 3, 4) in a single operation, to a heating apparatus (38) for heating which is uniform all round, which heating apparatus is spatially separated from the handling region (10) serving for the alignment of the substrates.

2. Apparatus for carrying out the process according to Claim 1, according to which a plurality of structured substrates (2, 3, 4) to be aligned with one another in accordance with their structure are to be stacked one above the other to form a substrate package (1) before they are joined together by bonding, at least one substrate (3) being non-transparent and having a fine, multiform, geometrically irregular structure, with design features of the structure of this substrate having to be aligned with design features of at least one of the other substrates,
characterised
a) in that, in a first working region (10) of a handling apparatus (12), means for receiving and holding (14) a substrate (2, 3, 4) are provided,
b) in that the means for receiving the substrate are situated on an adjusting table constructed as a coordinate table (13), the coordinate table (13) possessing precision drives (16) for all three degrees of freedom of a plane (X, Y, theta) for the purpose of changing the position of a substrate to be aligned,
c) in that, in the first working region (10) of the handling apparatus (12), a microscope system (30) is provided which images two spatially separated adjusting marks of a substrate situated in the receiving means,
d) in that, in a second working region (11) of the handling apparatus (12), means for receiving and holding (14) the aligned substrates to be successively deposited one on top of the other are provided, in that a holder (19, 21) which clamps the substrate package (1) at both end faces is provided,
e) in that transporting means (15) are provided which transport a substrate aligned in the first working region (10) to the second working region (11) of the handling apparatus (12) and deposit it there in accordance with the alignment effected in the first working region (10), and
f) in that, spatially separated from the first working region (10), a heating apparatus (38) is provided to which the entire substrate package (1) is fed in order to heat it uniformly all round for the bonding process.

3. Apparatus according to Claim 2,
characterised
in that the microscope system (30) provided in the first working region (10) of the handling apparatus (12) is a split-field microscope which images the spatially separated adjusting marks simultaneously.

4. Apparatus according to Claim 2 or 3, characterised in that the holder (19, 21) of the substrate package (1) are [sic] formed of a material with a coefficient of thermal expansion which corresponds to that of the substrates (2, 3, 4), and in that this holder contacts the substrates (2, 4) resting against it over a large area during the bonding.

5. Apparatus according to one of Claims 2 to 4,
characterised
in that the transporting means comprise a transporting slide (23), which is movable between fixed stops (22, 25), and a reciprocating device (26),
in that the receiving and holding means (14) include vacuum suction means, in that the handling apparatus (12) has a high mechanical stability for preserving the distance between the microscope system (30) and the receiving and holding means (14) and for preserving the reproducibility of the positioning of the transporting slide (23) at the fixed stops (22, 25) and in the stroke movement (Z), in that
an adjustable time delay between the lowering of the transporting slide (23) and the switching-off of the vacuum suction in the substrate receiver (14) for the purpose of displacing the air cushion between the substrates (2, 3, 4) to be stacked is provided, and in that
the substrate package (1) is held together by means of the holding plates (19, 21) which enclose the substrate stack, are mutually held by magnetic attraction and are guided with respect to one another by alignment pins (18).

6. Apparatus according to Claim 2,
characterised
in that the heating apparatus (38) is dimensioned so that it can also receive a plurality of substrate packages (1) simultaneously for the bonding operation.

7. Apparatus according to Claim 2,
characterised
in that, in the heating chamber (44) of the heating apparatus (38), means are provided which, upon introduction of one or more multi-layer glass-semiconductor-glass substrate packages (1), connect the anode of a high-voltage source (45) to the semiconductor substrate(s) (3) and connect the glass substrates (2, 4) to the cathode potential.

## Revendications

1. Procédé pour la fabrication d'un capteur d'accélération,
a) ledit capteur d'accélération étant constitué de substrats (2, 3, 4) disposés par couches avec des surfaces planes et parallèles qui doivent, avec leurs surfaces entières, être irréversiblement reliés par bonding les uns aux autres,
b) au moins un premier substrat (3) présentant sur sa surface des structures réalisées par gravure et au moins un autre substrat présentant sur sa surface également de fines structures importantes pour la fonction du capteur d'accélération,
c) au moins le premier substrat (3) avec les structures réalisées par gravure étant constitué d'un matériau non transparent,
d) le premier avec au moins respectivement l'un des autres substrats (2, 4) devant, à la préparation pour leur assemblage par bonding, être alignés l'un par rapport à l'autre avec une précision de l'ordre du micromètre, de telle sorte que des caractéristiques de configuration dirigées les unes vers les autres complètent leur structures pour en faire un capteur d'accélération capable de fonctionner,
caractérisé par le fait
e) que, successivement, les substrats (2, 3, 4) à empiler les uns sur les autres sont tout d'abord alignés dans un premier domaine de travail (10) d'un dispositif de manipulation (12), transportés ensuite à un second domaine de travail (11) dudit dispositif de manipulation (12) et déposés à cet endroit les uns sur les autres conformément à l'alignement adopté,
f) un microscope (31, 32) étant dirigé sur le substrat situé dans le premier domaine de travail (10) du dispositif de manipulation (12) afin de visualiser deux repères d'ajustage spatialement séparés du substrat sur un support d'image (35, 36), les repères d'ajustage étant formés par des caractéristiques de configuration des structures du substrat même ou, séparément de celles-ci, par des marquages autonomes sur la surface des substrats et
g) que la position réelle du substrat situé dans le premier domaine de travail (10) du dispositif de manipulation (12) sera modifiée par rotation et déplacement des moyens montés mobiles pour le logement et la fixation (14) du substrat jusqu'à ce que la reproduction des repères d'ajustage coïncide avec une position de référence (28, 29) prédéterminée sur le support d'image (35, 36), et
h) que le paquet de substrats (1), en conservant l'alignement auparavant adopté de ses substrats, enserré dans son ensemble entre un dispositif de fixation (19, 21) encadrant ledit paquet de substrats (1) aux deux faces frontales pour le bonding simultané de tous ses substrats (2, 3, 4) en une seule phase de travail, est acheminé pour l'échauffement uniforme de tous côtés à un dispositif de chauffage (38) spatialement séparé du dispositif de manipulation (10) servant à l'alignement des substrats.

2. Dispositif pour l'exécution du procédé selon la revendication 1 conformément à laquelle plusieurs substrats structurés (2, 3, 4) devant être alignés conformément à leurs structures les uns par rapport aux autres doivent être empilés, avant leur assemblage par bonding, les uns sur les autres en un paquet de substrats (1), au moins l'un des substrats (3) n'étant pas transparent et présentant une structure fine, multiforme, géométriquement irrégulière, des caractéristiques de configuration de la structure de ce substrat devant être alignées d'après des caractéristiques de configuration d'au moins l'un des autres substrats,
caractérisé par le fait
a) que dans un premier domaine de travail (10) d'un dispositif de manipulation (12) sont prévus des moyens pour le logement et la fixation (14) d'un substrat (2, 3, 4),
b) que lesdits moyens pour le logement du substrat sont situés sur une unité d'ajustage réalisée sous forme de platine à chariot bidirectionnel (13), ladite platine à chariot bidirectionnel (13) disposant, pour tous les trois degrés de liberté d'un plan (X, Y, Thêta), d'entraînements de précision (16) pour la variation positionnelle d'un substrat à aligner,
c) que dans le premier domaine de travail (10) du dispositif de manipulation (12) est prévu un système de microscope (30) qui visualise deux repères d'ajustage spatialement séparés d'un substrat situé dans les moyens de logement,
d) que dans un second domaine de travail (11) du dispositif de manipulation (12) sont prévus des moyens pour le logement et la fixation (14) des substrats alignés devant être empilés successivement et les uns sur les autres, qu'il est prévu un dispositif de fixation (19, 21) qui enserre le paquet de substrats (1) aux deux faces frontales,
e) que des moyens de transport (15) sont prévus qui transportent un substrat aligné dans le premier domaine de travail (10) au second domaine de travail (11) du dispositif de manipulation (12) et le déposent à cet endroit conformément à l'alignement adopté dans le premier domaine de travail (10) et
f) que, spatialement séparé du premier domaine de travail (10), est prévu un dispositif de chauffage (38) auquel est acheminé l'ensemble du paquet de substrats (1) afin d'être chauffé uniformément de tous côtés pour le processus du bonding.

3. Dispositif selon la revendication 2,
caractérisé par le fait
que le système de microscope (30) prévu dans le premier domaine de travail (10) du dispositif de manipulation (12) est un microscope splitfield qui visualise simultanément les repères d'ajustage spatialement séparés.

4. Dispositif selon l'une quelconque des revendications 2 ou 3,
caractérisé par le fait
que le dispositif de fixation (19, 21) du paquet de substrats (1) est constitué en un matériau dont le coefficient de dilatation thermique correspond à celui des substrats (2, 3, 4) et que ce dispositif de fixation établit, pendant le bonding, un contact de grande surface entre les substrats adjacents (2, 4).

5. Dispositif selon l'une quelconque des revendications 2 à 4,
caractérisé par le fait
que les moyens de transport sont constitués d'un chariot de transport (23), qui est déplaçable entre des butées stationnaires (22, 25), et d'un dispositif de levage (26), que les moyens (14) pour le logement et la fixation contiennent des moyens pour l'aspiration par le vide,
que, pour la conservation de la distance entre le système de microscope (30) et les moyens pour le logement et la fixation (14) ainsi que pour la conservation de la reproductibilité du positionnement du chariot de transport (23) aux butées stationnaires (22, 25) et dans le mouvement de levage (Z), le dispositif de manipulation (12) présente une haute stabilité,
qu'il est prévue une temporisation réglable entre l'abaissement du chariot de transport (23) et la mise à l'arrêt de l'aspiration par le vide dans le logement de substrats (14) pour l'expulsion du coussin d'air existant entre les substrats à empiler (2, 3, 4) et
que la cohésion du paquet de substrats (1) est réalisée au moyen des plaques de contention (19, 21) qui encadrent l'empilage de substrats, se retiennent mutuellement par attraction magnétique et sont guidées, l'une vers l'autre, par des goujons d'assemblage (18).

6. Dispositif selon la revendication 2,
caractérisé par le fait
que le dispositif de chauffage (38) est dimensionné de telle sorte qu'il puisse aussi loger simultanément plusieurs paquets de substrats (1) pour le processus de bonding.

7. Dispositif selon la revendication 2,
caractérisé par le fait
que dans la chambre de chauffage (44) du dispositif de chauffage (38) sont prévus des moyens qui, lors de la mise en place d'un ou plusieurs paquets de substrats multicouches verre-semi-conducteurs-verre (1), relient l'anode d'une source à haute tension (45) au substrat à semi-conducteurs ou aux substrats à semi-conducteurs (3) et connectent les substrats de verre (2, 4) au potentiel de cathode.
